Europäisches Patentamt

**European Patent Office**

Office européen des brevets

(19)

(11) Publication number: **0 138 515**
A2

# EUROPEAN PATENT APPLICATION

(21) Application number: **84306754.7**

(22) Date of filing: **04.10.84**

(51) Int. Cl.⁴: **C 23 C 14/24**

(30) Priority: **07.10.83 JP 186965/83**

(43) Date of publication of application: **24.04.85**
Bulletin 85/17

(84) Designated Contracting States: **CH DE FR GB IT LI NL**

(71) Applicant: **NIHON SHINKU GIJUTSU KABUSHIKI KAISHA also trading as ULVAC CORPORATION, 2500, Hagizono, Chigasaki-shi Kanagawa-ken (JP)**

(72) Inventor: **Nakamura, Kyuzo, 672-20, Yachimata Ho Yachimatamachi, Inba-gun Chiba-ken (JP)**
Inventor: **Ota, Yoshifumi, 129, Yachimata Ni Yachimatamachi, Inba-gun Chiba-ken (JP)**
Inventor: **Yamada, Taiki, 617-2, Asahi Yachimatamachi, Inba-gun Chiba-ken (JP)**
Inventor: **Ishikawa, Michio, 617-2, Asahi Yachimatamachi, Inba-gun Chiba-ken (JP)**
Inventor: **Tani, Noriaki, 617-2, Asahi Yachimatamachi, Inba-gun Chiba-ken (JP)**

(74) Representative: **Billington, Lawrence Emlyn et al, HASELTINE LAKE & CO Hazlitt House 28 Southampton Buildings Chancery Lane, London WC2A 1AT (GB)**

(54) **An apparatus for use in manufacturing a perpendicular magnetic recording member.**

(57) An apparatus for use in manufacturing a perpendicular magnetic recording member, the apparatus comprising a vacuum treatment chamber (1), support means (6) for supporting a non-magnetic substrate (5) in the vacuum treatment chamber (1), evaporating means (4) for evaporating magnetic metal or alloy (2) substantially perpendicularly onto a surface of said substrate (5), and oxygen inlet means (8, 9) arranged for introducing into the vacuum treatment chamber (1) oxygen gas to partly oxidise the vapor of the magnetic material (2) when the latter is deposited on said surface of said substrate (5), the interior of the vacuum treatment chamber (1) being divided by a partition (14) so that surfaces within the vacuum treatment chamber (1) which will be contacted by said oxygen gas, other than said surface of said substrate (5), will be shielded from the vapor of the evaporated magnetic material (2) when the apparatus is in use.

ACTORUM AG

-1-

# AN APPARATUS FOR USE IN MANUFACTURING A
## PERPENDICULAR MAGNETIC RECORDING MEMBER

This invention relates to an apparatus for use in manufacturing a perpendicular magnetic recording member.

There has been hitherto proposed by the applicants of this application such an apparatus in which a magnetic material comprising a magnetic metal or alloy is so evaporated as to be incident substantially perpendicularly to a surface of a non-magnetic substrate. The latter is arranged in a vacuum treatment chamber so as to face downwards, and the vapor of the magnetic material is deposited on the substrate while being partly oxidized by oxygen gas introduced into the treatment chamber. There is thus manufactured a perpendicular magnetic recording member having a perpendicular magnetic film comprising two phases of magnetic particles grown up in a columnar form and oxide particles constituting part thereof.

As a result of various studies and researches, it has been found that this type of member is defective in that during its manufacture as described, even if the flow rate of the introduced oxygen gas is kept constant, an oxygen partial pressure in the vacuum treatment chamber fluctuates substantially. Consequently, the resultant perpendicular magnetic film varies comparatively widely in its oxygen content. The perpendicular magnetic property of the film varies according to that variation in oxygen content, and thus there cannot be obtained a uniform product.

The cause of this problem is that the evaporated magnetic metal such as Co, Fe, Ni or the like, or the evaporated alloy thereof, adheres to a side wall of the treatment chamber, to an adhesion preventing plate, or to other equipment provided in the chamber. The adhered particles of magnetic metal or alloy act as a getter of the introduced oxygen gas and perform a pump action which effectively reduces the oxygen content of the chamber atmosphere. This pump action is substantially in proportion to the area to which those metallic particles or atoms are adhered. In the previously proposed apparatus, the metallic atoms adhere substantially to the whole interior surface of the treatment chamber. The contact area of the metallic atoms with the oxygen gas is thus extremely large, and the aforementioned pump action becomes very large in accordance with this large contact area. Therefore, the oxygen partial pressure in the treatment chamber is changed substantially even by merely a slight change in evaporation rate. The result is an end product having a perpendicular magnetic film whose oxygen content fluctuates substantially and is not uniform.

According to the present invention there is provided an apparatus for use in manufacturing a perpendicular magnetic recording member, the apparatus comprising a vacuum treatment chamber, support means for supporting a non-magnetic substrate in the vacuum treatment chamber, evaporating means for evaporating magnetic metal or alloy substantially perpendicularly onto a surface of said substrate, and oxygen inlet means arranged for introducing into the vacuum treatment chamber oxygen gas to partly oxidise the vapor of the magnetic material when the latter is deposited on said surface of said substrate, the interior of the vacuum treatment chamber being divided by a partition so that surfaces within the vacuum treatment chamber which will be contacted by said oxygen gas, other than said surface of said substrate, will be shielded from the vapor of the evaporated magnetic material when the apparatus is in use.

A preferred embodiment of the invention may provide an apparatus which can manufacture a perpendicular magnetic film of good quality and having a small variation in oxygen content, as will be described hereinafter.

For a better understanding of the invention and to show how it may be put into effect, reference will now be made by way of example, to the accompanying drawings in which:

Fig.1 is a sectional view of an apparatus according to one embodiment of this invention;

Figs.2 and 3 are sectional views of modified versions of Fig.1;

Fig.4A is an oxygen content distribution diagram of a film manufactured using an embodiment of this invention;

Fig.4B is a similar diagram of a film manufactured using a previously proposed apparatus;

Fig.5A is a magnetic property diagram of a perpendicular magnetic recording member manufactured using an embodiment of this invention; and

Fig.5B is a similar diagram of a perpendicular magnetic member manufactured using a previously proposed apparatus.

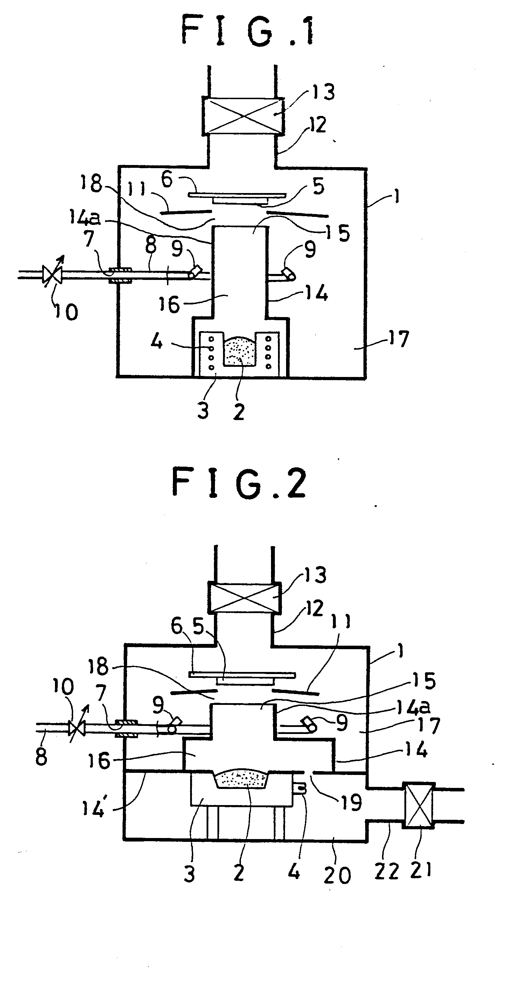

Figure 1 shows an embodiment of the present invention comprising a vacuum treatment chamber 1. A magnetic material 2 which is a magnetic metal such as Fe, Ni, Co or the like, or an alloy thereof, is provided at a lower portion of the interior of the treatment chamber 1 in a crucible 3. The magnetic material 2 may be heated and evaporated by a heating source 4, which may be a radiation heater or a high frequency induction heater provided around the material 2.

A plate-shaped non-magnetic substrate 5 made of metal, synthetic resin, ceramics or the like is provided just above the magnetic material 2 in such a manner that the substrate 5 is so held horizontally by a holding means 6 as to face downwards. An oxygen gas supply pipe 8 is passed air-tightly through an opening 7 made in a side wall of the treatment chamber 1, and nozzles 9 of a forward end of an introduced portion of the pipe 8 are so arranged as to direct a flow of oxygen gas towards the downwardly-directed surface of the substrate 5. Numeral 10 denotes a flow rate control valve interposed in the oxygen gas supply pipe 8, numeral 11 denotes an adhesion preventing plate surrounding the outer periphery of the substrate 5, numeral 12 denotes an evacuation conduit pipe connected to a vacuum pump (not shown) and numeral 13 denotes a control valve interposed in the conduit pipe 12.

The construction as so-far described is not particularly different from the previously proposed construction.

The treatment chamber 1 has its interior partitioned by a partition wall 14 into, firstly, an evaporation chamber 16 housing therein the magnetic material 2 and having an open end 15 facing the substrate 5, and secondly an oxygen gas introducing chamber 17.

In the illustrated example, the partition wall 14 is formed as a tubular wall surrounding the magnetic material 2 and the outer periphery of the crucible 3 with the heating source 4 built therein. An upper portion of the tubular wall 14 is formed as a guide tube 14a extending to a position near the lower surface of the substrate 5. This upper portion of the tubular wall 14 guides the vapor of the magnetic metal or alloy 2 to the lower surface of the substrate 5, and the area of the open upper end 15 is made to be nearly equal to that of the surface of the substrate 5 to be coated by the vapor.

Between the upper end 15 of the guide tube 14a and the lower surface of the substrate 5, there is left a space 18 in which the foregoing vapor is to contact and react with the introduced oxygen gas. The foregoing oxygen gas supply pipe 8 is so constructed that the introduced portion thereof is an annular pipe portion surrounding the guide tube 14a. A plurality of the nozzles 9 directed towards the substrate 5 located above, are arranged at regular intervals along this annular pipe portion.

The operation of the foregoing apparatus will be explained as follows:-

The interior of the treatment chamber 1 is evacuated down to a predetermined value, and the magnetic material 2 is heated and evaporated by the heating source 4. The resultant vapor is guided by the guide tube 14a to rise vertically and is caused to be indicent on, and deposit substantially perpendicular to, the surface of the substrate 5. In the course of this operation, in the space 18 part of the vapor is brought into contact and reacts with the oxygen gas introduced into the oxygen gas introducing chamber 17 at a constant flow rate through the oxygen gas supply pipe 8. The result is an oxide of the vapor which is deposited perpendicularly on the surface of the substrate 5. Thus, there is obtained on the substrate 5 surface a perpendicularly grown-up magnetic film of two phases of ferromagnetic particles and non-magnetic oxide particles. It is preferable to manufacture the film in such a condition that the composition thereof has a general formula of $(Fe_x Co_y Ni_z)_{1-m} O_m$, and a composition ratio of (1) $0.40 \leqq x \leqq 1.0$, $0 \leqq z \leqq 0.25$, $0.25 \leqq m \leqq 0.5$ (herein, $x + y + z = 1$) or (2) $0 \leqq x \leqq 0.05$, $0 \leqq z \leqq 0.40$, $0.15 \leqq m \leqq 0.50$.

During the foregoing operation, hardly any of the vapor of the magnetic metal or alloy escapes into the oxygen gas introducing chamber 17 separated from the

-6-

evaporation chamber 16 by means of the partition wall 14. Accordingly, hardly any of the vapor adheres to the wall of the oxygen gas introducing chamber 17, or the adhesion preventing plate 11, or any of the other equipment provided therein. As a result, the getting action exerted on the oxygen gas by adhered magnetic metallic vapor, and the subsequent pump action as experienced in the previously proposed apparatus which lacks the partition wall 14, can be remarkably decreased. In the present apparatus therefore , one can produce consistent products each of which has a perpendicular magnetic film containing uniformly the predetermined oxygen atoms.

Fig.2 shows a modified example of the inventive apparatus of Fig.1. In this example, an electron beam gun chamber 20 houses therein a heating source 4 of an electron beam type and is separated from the evaporation chamber 16 by an additional partition wall 14'. The latter is provided with a small communication opening 19 formed in the treatment chamber 1 at the bottom of the evaporation chamber 16. The side surface of the gun chamber 20 is connected to the foregoing vacuum pump (or another vacuum pump) through an evacuation conduit pipe 22 having a control valve 21 interposed therein so that the gun chamber 20 may undergo a differential evacuation. In this way the gun filament of the heating source 4 may be kept in a high vacuum condition in order to be securely protected from being oxidized by the introduced oxygen gas. In the meantime, the electron beam generated by the gun 4 may serve to heat and evaporate the magnetic material 2 in the evaporation chamber 16 through the communication opening 19. The opening 19 may have the minimum diameter allowing the electron beam to pass therethrough.

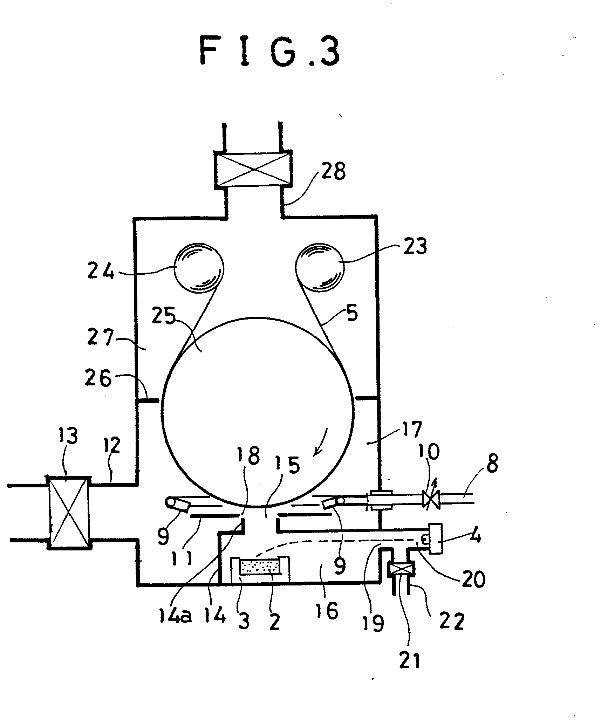

Fig.3 shows another modified example of the inventive apparatus. Instead of the foregoing plate-shaped substrate 5, the substrate 5 in this example is a plastics tape film which may be treated with a perpendicular vapor deposition to provide a perpendicular magnetic recording member. The substrate 5 extends between an unwinding roll 23 and a winding roll 24 through or about an intermediate cooling can or drum 25, and travels at a constant speed so that the vapor of the magnetic material 2 rising from the evaporation chamber 16 may be deposited perpendicularly and continuously on a lower surface of a nearly horizontal surface portion of the substrate 5, positioned at a lower extremity of the cooling can 25. The introduced portion of the oxygen gas supply pipe 8 is located above the adhesion preventing plate 11 and is in an annular form around the plate 11. The lower extremity of the cooling can 25 and the nozzles 9 are so arranged with respect to each other that the nozzles 9 are directed towards the lower extremity of the substrate 5.

Additionally, the oxygen gas introducing chamber 17 is partitioned by a partition wall 26 into two so as to form an isolated chamber 27 for housing the unwinding and winding rolls 23 and 24. The chamber 27 is arranged to be evacuated through an evacuation conduit pipe 28 connected to its own vacuum pump (not shown), so that any gas given-off from the unwound roll side of the tape-shaped substrate 5 may be removed and, accordingly, the impurity gas partial pressure in the oxygen gas introducing chamber 17 may be lowered. The evaporation chamber 16 and the oxygen gas introducing chamber 17 are provided with respective evacuation conduit pipes 22 and 12 connected to vacuum pumps (not shown).

An electron beam gun chamber 20 is provided on a side surface of the treatment chamber 1 and is in communication with the evaporation chamber 16 through the communication opening 19 made in the side wall of the

-8-

treatment chamber 1. A side surface of the chamber 20 is provided with the evacuation conduit pipe 22.

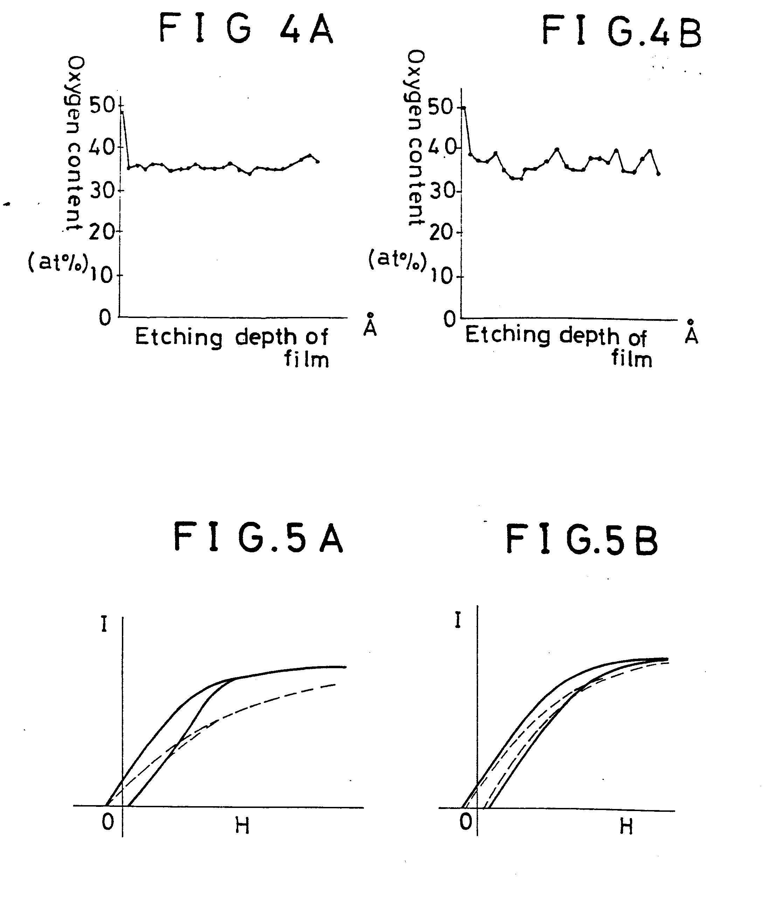

The content of oxygen atoms in the direction of the thickness of a film of a magnetic tape having a Co-O series perpendicular magnetic film manufactured by the apparatus shown in Fig.3 was measured while it was etched in its film thickness direction. The results are shown in Fig.4A. For comparison purposes, the content of oxygen atoms was measured in the film thickness direction of a magnetic tape having a Co-O series perpendicular magnetic film of 5000 Å in thickness. This tape was manufactured by an apparatus which is substantially the same as that hereinbefore described, except that the partition wall 14 of the evaporation chamber 16 was removed. The result thereof is shown in Fig.4B.

As will be clear from Figures 4A and 4B, when using the inventive apparatus the value of the oxygen content in the film fluctuates less, and there can be obtained a film in which the value of the oxygen content is substantially the same at every position in the depth direction of the film.

A hysteresis cycle of the foregoing magnetic tape manufactured in apparatus according to this invention is shown in Fig.5A, and a hysteresis cycle of the magnetic tape manufactured for the foregoing comparison purpose is shown in Fig.5B. The solid line shows the perpendicular magnetic property thereof, and the dotted line shows the horizontal magnetic property thereof. As will be clear from Figures 5A and 5B, the magnetic tape manufactured by the inventive apparatus is remarkably better as regards its perpendicular magnetic property.

Thus, according to preferred embodiments of this invention, a vacuum treatment chamber 1 is partitioned at its interior by a partition wall 14 into an oxygen gas introducing chamber 17 and an evaporation chamber 16

0138515

housing therein a magnetic material 2 and having an open surface 15 facing a substrate 5. The preferred embodiments can be used to manufacture a good perpendicular magnetic recording member which is substantially uniform in oxygen contained therein and is excellent in perpendicular magnetic property, when compared with a perpendicular magnetic recording member which is manufactured by an apparatus which is lacking in such a partition wall 14.

CLAIMS

1. An apparatus for use in manufacturing a perpendicular magnetic recording member, the apparatus comprising a vacuum treatment chamber, support means for supporting a non-magnetic substrate in the vacuum treatment chamber, evaporating means for evaporating magnetic metal or alloy substantially perpendicularly onto a surface of said substrate, and oxygen inlet means arranged for introducing into the vacuum treatment chamber oxygen gas to partly oxidise the vapor of the magnetic material when the latter is deposited on said surface of said substrate, the interior of the vacuum treatment chamber being divided by a partition so that surfaces within the vacuum treatment chamber which will be contacted by said oxygen gas, other than said surface of said substrate, will be shielded from the vapor of the evaporated magnetic material when the apparatus is in use.

2. An apparatus according to claim 1, wherein the partition divides the interior of the vacuum treatment chamber into an oxygen gas introduction region, and an evaporation region leading from the magnetic material to said surface of said substrate.

3. An apparatus according to claim 2, wherein the evaporation region has an opening defined by the partition and leading out onto said surface of said substrate.

4. An apparatus according to claim 2 or 3, wherein said evaporation region is in the form of a chamber adapted for housing the magnetic material.

5. An apparatus according to claims 2, 3 and 4 combined, wherein the partition is tubular having a first portion to surround the magnetic material, and a second portion providing a vapor guide tube extending to a position adjacent said surface of said substrate.

-11-

6.     An apparatus according to any preceding claim, wherein said support means is arranged to direct said surface of said substrate downwardly, whereby the vapor rises to be deposited on said surface when the apparatus is in use.

# F I G .1

# F I G .2

# F I G . 3

# F I G 4 A

# F I G.4 B

# F I G.5 A

# F I G.5 B